# EUROPÄISCHE PATENTANMELDUNG

(11) **EP 3 982 503 A1**
(43) Veröffentlichungstag der Anmeldung: **13.04.2022**
(21) Anmeldenummer: 20200786.0
(22) Anmeldetag: 08.10.2020
(51) Int. Cl.: H02J 3/24, G01R 31/00

(54) **VERFAHREN, EINRICHTUNG UND SYSTEM ZU ERKENNEN EINER ELEKTRISCHEN PENDELUNG IN EINEM ELEKTRISCHEN ENERGIEVERSORGUNGSNETZ**

(71) Anmelder: Siemens Aktiengesellschaft, 80333 München (DE)
(72) Erfinder: Litzinger, Andreas, 90765 Fürth (DE); Piel, Stefan, 45359 Essen (DE); Voigt, Reinhold, 91244 Reichenschwand (DE)

(57) **Zusammenfassung**

Die Erfindung betrifft ein Verfahren zum Erkennen einer elektrischen Pendelung in einem elektrischen Energieversorgungsnetz, bei dem für zumindest eine Messstelle (21) in dem Energieversorgungsnetz eine elektrische Pendelgröße bestimmt wird, auf Basis eines zeitlichen Verlaufs der Pendelgröße für die zumindest eine Messstelle (21) Parameter einer elektrischen Pendelung berechnet werden und unter Verwendung der Parameter auf das Vorliegen und die Art einer elektrischen Pendelung geschlossen wird.

Um frühzeitig nach Eintritt einer Pendelung korrekte Parameter zur Bewertung der Pendelung zur Verfügung zu stellen, wird vorgeschlagen, dass die Anzahl derjenigen aufeinanderfolgenden Werte der Pendelgröße, aus denen die Parameter der elektrischen Pendelung berechnet werden, dynamisch an den Verlauf der Werte der Pendelgröße angepasst wird.

## Beschreibung

Die Erfindung betrifft ein Verfahren zum Erkennen einer elektrischen Pendelung in einem elektrischen Energieversorgungsnetz, bei dem für zumindest eine Messstelle in dem Energieversorgungsnetz eine elektrische Pendelgröße bestimmt wird, auf Basis eines zeitlichen Verlaufs der Pendelgröße für die zumindest eine Messstelle Parameter einer elektrischen Pendelung berechnet werden, und unter Verwendung der Parameter auf das Vorliegen und die Art einer elektrischen Pendelung geschlossen wird. Die Erfindung betrifft auch eine Einrichtung und ein System zum Erkennen einer elektrischen Pendelung.

Um einen reibungslosen und sicheren Betrieb elektrischer Energieversorgungsnetze zu gewährleisten, werden in sogenannten Netzleitstellen für den Netzzustand charakteristische Messwerte des elektrischen Energieversorgungsnetzes überwacht, um zu ermitteln, ob sich das Energieversorgungsnetz in seinem bestimmungsgemäßen Betriebszustand oder aber einem kritischen Zustand befindet. Hierzu werden an ausgewählten Messstellen des elektrischen Energieversorgungsnetzes Messwerte elektrischer Messgrößen, wie z.B. Strom, Spannung und Leistung, mittels geeigneter Wandler erfasst und üblicherweise in digitaler Form der Netzleitstelle zur Auswertung und Beobachtung zugeführt. Um einen zeitlichen Bezug der einzelnen Messwerte zueinander zu gewährleisten, werden die aufgenommenen Messwerte üblicherweise um sogenannte Zeitstempel, also Uhrzeitinformationsdaten, ergänzt, die z.B. diejenige Uhrzeit angeben, zu denen die Messwerte erfasst worden sind.

Eine Form eines kritischen Betriebszustands eines elektrischen Energieversorgungsnetzes stellen sogenannte "elektrische Pendelungen" (im Folgenden auch schlicht als "Pendelungen" bezeichnet) dar. Solche Pendelungen entstehen z.B. bei plötzlichen Laständerungen oder Veränderungen an der Struktur des elektrischen Energieversorgungsnetzes (beispielsweise durch Zu- oder Abschalten größerer Netzteile). Hierbei müssen sich die Generatoren an den Einspeisestellen des elektrischen Energieversorgungsnetzes auf die neue Lastsituation einstellen. Dies geschieht üblicherweise in Form einer gedämpften Schwingung mit einer Frequenz von bis zu wenigen Hertz, bis sich der neue Arbeitspunkt des elektrischen Energieversorgungsnetzes stabilisiert hat. Durch das Einschwingverhalten der Generatoren werden pendelnde Strom- und Spannungszustände im Energieversorgungsnetz erzeugt, die unterschiedliche Auswirkungen auf das Energieversorgungsnetz und seine elektrischen Komponenten (z.B. Leitungen, Kabel, Transformatoren) haben können. Während gedämpfte, schnell abklingende Pendelungen mit vergleichsweise niedrigen Amplituden im Energieversorgungsnetz akzeptiert werden können, stellen insbesondere schwach gedämpfte oder sogar sich aufschaukelnde Pendelungen einen höchst kritischen Zustand des Energieversorgungsnetzes dar, der leicht zu Ausfällen und Abschaltungen größerer Netzabschnitte führen kann. Außerdem kann durch die sich bei Ausfällen einzelner Netzabschnitte sprunghaft verändernde Netzstruktur eine Überlastung noch funktionsfähiger Abschnitte des elektrischen Energieversorgungsnetzes erfolgen, was zu kaskadierenden Abschaltungen bis hin zu einem sogenannten Blackout führen kann. Daher sind insbesondere solche als kritisch einzustufenden Pendelungen unverzüglich dem Leistellen-Betriebspersonal des elektrischen Energieversorgungsnetzes zu signalisieren.

Hierzu werden Messwerte beispielsweise mit sogenannten Zeigermesseinrichtungen bzw. "Phasor Measurement Units" (PMU) als komplexe Strom- oder Spannungszeiger erfasst, die eine Aussage über Amplitude und Phasenwinkel der an der jeweiligen Messstelle des elektrischen Energieversorgungsnetzes zu messenden Messgröße umfassen. Solche Zeigermesswerte werden mit hohen Abtastraten erfasst, um z.B. Lastflüsse und mögliche Pendelungen noch genauer erkennen zu können und ggf. geeignete Gegenmaßnahmen zur Abwendung sich ankündigender instabiler Zustände einzuleiten. Ein beispielhaftes Verfahren, mit dem anhand von Zeigermesswerten auf das Vorliegen von Pendelungen in einem Energieversorgungsnetz geschlossen werden kann, ist aus der Europäischen Patentschrift EP 2774242 B1 bekannt.

Wenn Pendelungen in elektrischen Energieversorgungsnetzen nicht kontrolliert werden können, können sie zu erheblichen Störungen der elektrischen Betriebsmittel bis hin zum Totalausfall ganzer Netzbereiche führen. Eine frühzeitige Erkennung solcher Phänomene unter Angabe verlässlicher Kenngrößen (Parameter) zu ihrer Bewertung ist daher von großer Bedeutung für die Sicherstellung der elektrischen Energieversorgung. Dies gilt insbesondere dann, wenn automatische Schaltmaßnahmen zur Beseitigung solcher Pendelereignisse zur Vermeidung weitreichender Störungen beabsichtigt sind.

Es gibt eine Vielzahl unterschiedlicher Ansätze zur Erkennung und Bewertung von Pendelungen. Beispielsweise werden unter Verwendung aufeinanderfolgender Werte einer Pendelgröße, z.B. einer Wirkleistung, Parameter einer etwaigen Pendelung ermittelt und daraus auf das Vorliegen und ggf. die Art einer Pendelung geschlossen. Als Art einer Pendelung wird insbesondere eine Aussage darüber angesehen, ob es sich um eine gedämpfte oder eine ungedämpfte Pendelung handelt. Nachteilig bei den bekannten Methoden ist, dass sie mit einer festen Anzahl von für die Berechnung der Parameter heranzuziehenden Werten der Pendelgröße arbeiten. Somit vermengen sich insbesondere zu Beginn einer Pendelung solche Werte, die unter dem Einfluss der Pendelung bestimmt worden sind, mit solchen, die während einer ungestörten Phase des Netzbetriebs bestimmt worden sind. Hierdurch können bei der Berechnung der Parameter Fehler auftreten. Wenn solche fehlerhaft berechneten Parameter zur Bestimmung von Steuerhandlungen (z.B. Zu- oder Abschalten bestimmter Netzbereiche) für das elektrische Energieversorgungsnetz verwendet werden, können sich schädliche Auswirkungen für das Energieversorgungsnetz ergeben. Dies kann insbesondere dann vorliegen, wenn eine eigentlich ungefährliche gedämpfte Pendelung durch zu Beginn der Pendelung fehlerhaft berechnete Parameter als ungedämpfte Pendelung erkannt wird und daraufhin unnötige Gegenmaßnahmen eingeleitet werden, die das Energieversorgungsnetz destabilisieren.

Beispielhaft sei in diesem Zusammenhang angenommen, dass eine Bestimmung der Pendelgröße an der Messstelle regelmäßig aktualisiert wird und die Anzahl der für eine Berechnung der Parameter der Pendelung verwendeten Werte der Pendelgröße den Verlauf der Pendelgröße über die letzten vierzig Sekunden wiedergibt. In einem solchen Fall werden vergleichsweise lang die nicht von der Pendelung betroffenen Werte bei der Berechnung der Parameter die Ergebnisse dominieren, so dass die berechneten Parameter fehlerhaft sind.

Der Erfindung liegt daher die Aufgabe zugrunde, frühzeitig nach Eintritt einer Pendelung korrekte Parameter zur Bewertung der Pendelung zur Verfügung zu stellen.

Diese Aufgabe wird durch ein Verfahren der eingangs angegebenen Art gelöst, bei dem die Anzahl derjenigen aufeinanderfolgenden Werte der Pendelgröße, aus denen die Parameter der elektrischen Pendelung berechnet werden, dynamisch an den Verlauf der Werte der Pendelgröße angepasst wird.

Im Gegensatz zu dem bekannten Ansatz wird erfindungsgemäß somit die Anzahl der zur Berechnung der Parameter verwendeten Werte der Pendelgröße variabel gewählt, wobei sich die Anzahl dynamisch aus dem Verlauf der Pendelgröße ergibt. Damit kann vermieden werden, dass bei der Berechnung der Parameter eine Vielzahl von Werten verwendet wird, die nicht während der Pendelung bestimmt worden sind und daher das Ergebnis der Parameter-Berechnung verfälschen. Somit können vergleichsweise schneller als bisher korrekte Parameter zur Erkennung und Bewertung einer Pendelung bereitgestellt werden, so dass entsprechend früher ggf. notwendige Gegenmaßnahmen zur Netzstabilisierung eingeleitet werden können.

Konkret kann beispielsweise vorgesehen sein, dass als Pendelgröße eine elektrische Wirkleistung oder einer zur elektrischen Wirkleistung proportionale Größe verwendet wird. Eine zur elektrischen Wirkleistung proportionale Größe kann beispielsweise eine Differenz der Phasenwinkel zweier an unterschiedlichen Punkten gemessenen Spannungszeiger für kleine Winkeldifferenzen der Wirkleistung sein, die zwischen den Messpunkten transportiert wird. Prinzipiell kann jedoch jede elektrische Größe verwendet werden, die proportional zur elektrischen Wirkleistung ist.

Gemäß einer vorteilhaften Ausführungsform des erfindungsgemäßen Verfahrens kann beispielsweise vorgesehen sein, dass die Werte der Pendelgröße in einen Datenpuffer geschrieben werden, der als Ringspeicher betrieben wird.

Unter einem Ringspeicherbetrieb wird in diesem Zusammenhang die Vorgehensweise beim Abspeichern von Daten in einem Speicher angesehen, bei der ein jeweils neuster abgespeicherter Wert den jeweils ältesten Wert aus dem Speicher verdrängt.

Konkret kann in diesem Zusammenhang vorgesehen sein, dass die Länge eines Datenfensters, das festlegt, welche in dem Datenpuffer enthaltenen Werte der Pendelgröße zur Berechnung der Parameter verwendet werden, dynamisch an den Verlauf der Werte der Pendelgröße angepasst wird.

Hierbei wird ein Datenpuffer einer konstanten Speichergröße eingesetzt. Eine dynamische Auswahl der für die Berechnung der Parameter zu verwendenden Werte der Pendelgröße erfolgt bei dieser Ausführungsform durch Anpassung der Länge eines Datenfensters. Hierbei wird somit bei gleichbleibender Größe des Datenpuffers die Länge des Datenfensters beeinflusst.

Alternativ kann auch vorgesehen sein, dass die Größe des Datenpuffers dynamisch an den Verlauf der Werte der Pendelgröße angepasst wird.

Hierbei wird ein Datenpuffer verwendet, dessen für die Abspeicherung der Werte der Pendelgröße nutzbarer Speicherbereich dynamisch angepasst werden kann. Damit wird quasi die Größe des Datenpuffers selbst beeinflusst.

Eine weitere vorteilhafte Ausführungsform des erfindungsgemäßen Verfahrens sieht vor, dass der Beginn einer elektrischen Pendelung erkannt wird und für die Berechnung der Parameter der elektrischen Pendelung diejenigen Werte der Pendelgröße herangezogen werden, die nach dem Beginn der elektrischen Pendelung bestimmt worden sind.

Auf diese Weise kann sichergestellt werden, dass für die Berechnung der Parameter zumindest überwiegend solche Werte herangezogen werden, die während der Pendelung bestimmt worden sind. Der Beginn der Pendelung kann beispielsweise durch eine Sprungüberwachung erfolgen, bei der eine über einen Schwellenwert hinausgehende sprunghafte Änderung im Verlauf aufeinanderfolgender Werte der Pendelgröße erkannt wird.

Eine weitere vorteilhafte Ausführungsform des erfindungsgemäßen Verfahrens sieht vor, dass zur Berechnung der Parameter eine Transformation der Werte der Pendelgröße in den Frequenzbereich durchgeführt wird.

Üblicherweise werden die Werte der Pendelgröße im Zeitbereich bestimmt. Eine Transformation in den Frequenzbereich ermöglicht es, einzelne Pendelungen mit ihren charakteristischen Pendelfrequenzen ("Pendelmoden" bzw. "Moden") zu erkennen und bewerten zu können. Eine Transformation in den Frequenzbereich kann beispielsweise mittels einer Fast Fourier Transformation (FFT) erfolgen.

Die Anzahl der zur Berechnung der Parameter verwendeten Werte kann beispielsweise kontinuierlich angepasst werden. Als besonders vorteilhaft hat es sich jedoch herausgestellt, wenn die Anzahl in festen Schritten (Stufen) verändert wird. Beispielsweise kann hierbei vorgesehen sein, dass die Anzahl der zur Berechnung der Parameter verwendeten Werte der Pendelgröße einem Wert einer Zweierpotenz 2^{N} entspricht, wobei N aus dem Bereich der natürlichen Zahlen größer/gleich 3 zu wählen ist. Dies bietet sich insbesondere dann an, wenn eine Transformation der Werte mittels einer FFT in den Frequenzbereich erfolgt.

Gemäß einer weiteren vorteilhaften Ausführungsform des erfindungsgemäßen Verfahrens kann zudem vorgesehen sein, dass als Parameter der elektrischen Pendelung eine Amplitude und eine Dämpfung der elektrischen Pendelung berechnet werden.

Diese Kenngrößen eignen sich besonders gut zur Charakterisierung des Verhaltens und des Risikopotenzials einer Pendelung. Hohe Amplituden und niedrige oder sogar negative Dämpfungen weisen auf eine Pendelung mit einem hohen Risikopotenzial hin. Die Parameter "Amplitude" und "Dämpfung" können beispielsweise wie in der oben genannten EP 2774242 B1 beschrieben berechnet werden.

Eine weitere vorteilhafte Ausführungsform des erfindungsgemäßen Verfahrens sieht vor, dass die berechneten Parameter auf einer Anzeigevorrichtung einer das Energieversorgungsnetz überwachenden Datenverarbeitungseinrichtung angezeigt werden.

Eine solche Datenverarbeitungseinrichtung kann beispielsweise Teil einer Netzleitstelle sein, in der Informationen über den Betriebszustand des Energieversorgungsnetzes inkl. etwaiger vorliegender Pendelungen dem Betriebspersonal des Energieversorgungsnetzes angezeigt werden.

Gemäß einer weiteren vorteilhaften Ausführungsform des erfindungsgemäßen Verfahrens kann ferner vorgesehen sein, dass für den Fall, dass die berechneten Parameter eine nur schwach gedämpfte oder gar eine vollständig ungedämpfte (beides als "ungedämpft" bezeichnet) elektrische Pendelung angeben, ein Warnsignal erzeugt wird. In einer erweiterten Ausführungsform ist die Ausgabe bzw. das Anstehen des Warnsignals zudem von der zum jeweiligen Zeitpunkt vorhandenen Amplitude der Pendelung abhängig.

Konkret kann in diesem Zusammenhang schließlich vorgesehen sein, dass bei vorliegendem Warnsignal eine zur Dämpfung einer elektrischen Pendelung geeignete Gegenmaßnahme ausgelöst wird.

Geeignete Dämpfungsmaßnahmen können beispielsweise das Ansteuern von Schalteinrichtungen zum Zu- oder Abschalten bestimmter Netzteile, Generatoren und/oder Verbraucher sein. Auch können beispielsweise Netzfilter oder Kapazitäten bzw. Induktivitäten ins Netz geschaltet werden, um eine Dämpfung zu bewirken.

Die oben genannte Aufgabe wird auch durch eine Einrichtung zum Erkennen einer elektrischen Pendelung in einem elektrischen Energieversorgungsnetz mit einer Recheneinrichtung gelöst. Die Recheneinrichtung ist dabei dazu eingerichtet, für zumindest eine Messstelle in dem Energieversorgungsnetz eine elektrische Pendelgröße zu bestimmen, auf Basis eines zeitlichen Verlaufs der Pendelgröße für die zumindest eine Messstelle Parameter einer elektrischen Pendelung zu berechnen, und unter Verwendung der Parameter auf das Vorliegen und die Art einer elektrischen Pendelung zu schließen.

Erfindungsgemäß ist hierbei vorgesehen, dass die Recheneinrichtung dazu eingerichtet ist, die Anzahl derjenigen aufeinanderfolgenden Werte der Pendelgröße, aus denen die Parameter der elektrischen Pendelung berechnet werden, dynamisch an den Verlauf der Werte der Pendelgröße anzupassen.

Hinsichtlich der erfindungsgemäßen Einrichtung gelten alle zu dem erfindungsgemäßen Verfahren voranstehend und nachfolgend gemachten Ausführungen und umgekehrt in entsprechender Weise, insbesondere ist die erfindungsgemäße Einrichtung zur Durchführung des erfindungsgemäßen Verfahrens in jeder beliebigen Ausführungsform oder einer Kombination beliebiger Ausführungsformen eingerichtet. Auch hinsichtlich der Vorteile der erfindungsgemäßen Einrichtung wird auf die zu dem erfindungsgemäßen Verfahren beschriebenen Vorteile verwiesen.

Schließlich wird die oben genannte Aufgabe auch durch ein System zum Erkennen einer elektrischen Pendelung in einem elektrischen Energieversorgungsnetz gelöst. Das System weist hierbei mindestens eine erfindungsgemäße Einrichtung wie oben beschrieben auf, wobei die mindestens eine Einrichtung dazu ausgebildet ist, nach einem Verfahren gemäß einer der oben beschriebenen Ausführungsformen für mindestens zwei Messstellen in dem elektrischen Energieversorgungsnetz Parameter der elektrischen Pendelung zu bestimmen.

Ein solches System wird allgemein auch als Weitbereichsüberwachungssystem bzw. Wide Area Monitoring System (WAMS) bezeichnet. Wenn auch Optionen automatischer Eingriffe in den Netzbetrieb durch entsprechende automatisierte Steueranweisungen möglich sind, kann das System auch als WAMPC ("Wide Area Monitoring, Protection and Control") bezeichnet werden. Beide Varianten sollen nachfolgend als Weitbereichsüberwachungssystem angesehen werden.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Verfahrens und der erfindungsgemäßen Einrichtung in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Hierzu zeigen
- Figur 1: eine schematische Darstellung eines Beispiels eines Weitbereichsüberwachungssystems;
- Figur 2: einen Ausschnitt des Systems der Figur 1 mit einer Einrichtung zum Erkennen und Bewerten einer elektrischen Pendelung;
- Figur 3: ein Diagramm mit der Darstellung des Verlaufs einer gedämpften elektrischen Pendelung;
- Figur 4: ein gemessener Verlauf von WirkleistungsWerten während einer elektrischen Pendelung;
- Figur 5: mehrere Diagramme zur Erläuterung der dynamischen Auswahl von Werten zur Berechnung von Parametern einer elektrischen Pendelung; und
- Figur 6: mehrere Diagramme zur Erläuterung der Berechnung von Parametern einer elektrischen Pendelung.

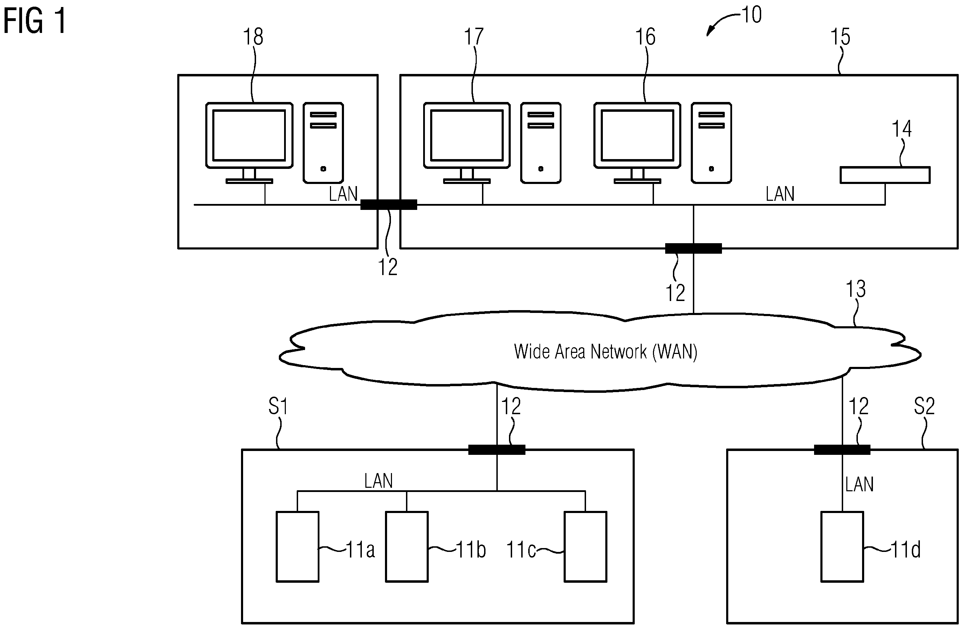

Figur 1 zeigt in schematischer Ansicht ein Beispiel eines Weitbereichsüberwachungssystems 10 ("Wide Area Monitoring System") zur Überwachung des Betriebs eines in Figur 1 der Übersichtlichkeit halber nicht gezeigten elektrischen Energieversorgungsnetzes.

Das Weitbereichsüberwachungssystem 10 umfasst auf der Ebene des Energieversorgungsnetzes angeordnete Feldgeräte 11a-d, mit denen durch Messung geeigneter elektrischer Messgrößen, wie z.B. Strom und Spannung, an mehreren Messstellen des Energieversorgungsnetzes Werte einer elektrischen Pendelgröße an der jeweiligen Messstelle ermittelt werden. Als Pendelgröße kann beispielsweise eine elektrische Wirkleistung oder eine Phasenwinkeldifferenz von an zwei Messstellen aufgenommenen Spannungszeigern verwendet werden. Nachfolgend wird als Pendelgröße beispielhaft eine elektrische Wirkleistung angenommen.

Beispielhaft sei angenommen, dass die Feldgeräte 11a-c im Bereich einer ersten Unterstation ("Substation") S1 angeordnet sind, während das Feldgerät 11d im Bereich einer zweiten Unterstation S2 angeordnet ist. Selbstverständlich sind auch andere Topologien denkbar, so dass die hier gezeigte Anordnung und Aufteilung lediglich als Beispiel zu verstehen ist.

Bei den Feldgeräten 11a-d kann es sich z.B. um sogenannte Zeigermesseinrichtungen ("Phasor Measurement Units") handeln, die dazu eingerichtet sind, Zeiger der jeweiligen Messgröße (z.B. Stromzeiger, Spannungszeiger) zu erfassen und mit einem genauen Zeitstempel zu versehen. Solche Zeigermesswerte umfassen jeweils die Angabe einer Amplitude und eines Phasenwinkels der jeweiligen Messgröße.

Die Feldgeräte 11a-e sind über lokale Netzwerke ("LAN"), entsprechende Router bzw. Gateways 12 und ein Weitbereichsnetzwerk 13 ("Wide Area Network WAN") mit einer Einrichtung 14 zum Erkennen einer elektrischen Pendelung in dem Energieversorgungsnetz verbunden. Diese kann beispielsweise Teil einer Netzleitstelle 15 sein. Mit der Einrichtung 14 zum Erkennen der Pendelung können außerdem über ein lokales Netzwerk der Netzleitstelle 15 auch eine Engineering-Station 16 zur Konfiguration der Einrichtung 14 und eine Betriebsstation 17 (Operator Working Station) verbunden sein, mit der auf die Einrichtung 14 zugegriffen werden kann und Ergebnisse von mit der Einrichtung 14 durchgeführten Berechnungen angezeigt werden können. Darüber hinaus können weitere Betriebsstationen 18 auch außerhalb der Netzleitstelle 15 Zugriff auf die Einrichtung 14 ermöglichen.

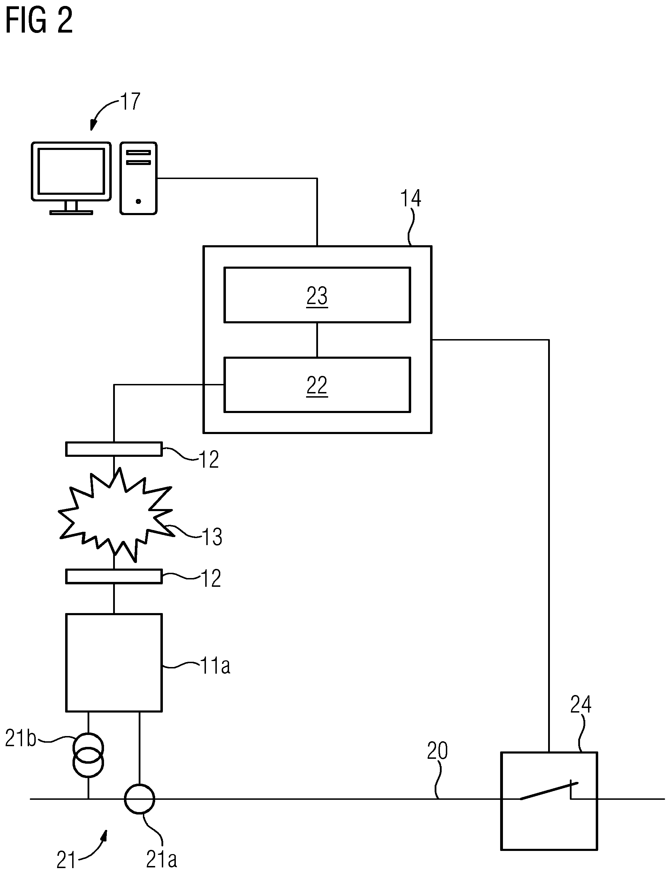

Anhand der Figuren 2 bis 6 soll nachfolgend die Vorgehensweise zum Erkennen einer Pendelung erläutert werden. Dazu zeigt Figur 2 einen Ausschnitt des Weitbereichsüberwachungssystems 10 der Figur 1. Einander entsprechende Komponenten sind hierbei mit identischen Bezugszeichen gekennzeichnet.

Figur 2 zeigt eine Leitung 20 eines ansonsten nicht weiter dargestellten Energieversorgungsnetzes. An einer Messstelle 21 werden mit entsprechenden Sensoren, die vorliegend lediglich beispielsweise als induktive Stromwandler 21a und Spannungswandler 21b angedeutet sind, Signale elektrischer Messgrößen (hier: Strom und Spannung) erfasst und dem Feldgerät 11a zugeführt. Mit dem Feldgerät 11a werden die erfassten Signale in digitale Messwerte gewandelt und mit einem genauen Zeitstempel versehen. Daraufhin kann in dem Feldgerät 11a aus zueinander gehörenden Messwerten eine Berechnung von Wirkleistungs-Werten erfolgen, die daraufhin über Gateways/Router 12 und das Netzwerk 13 an die Einrichtung 14 zum Erkennen einer Pendelung weitergeleitet werden. Alternativ können auch die zeitgestempelten Messwerte direkt an die Einrichtung 14 übertragen werden. In diesem Fall werden die Wirkleistungs-Werte erst in der Einrichtung 14 berechnet.

Neben dem Feldgerät 11a können - wie in Figur 1 gezeigt - an weiteren Messstellen weitere Feldgeräte vorhanden sein, mit denen zur Bestimmung der Wirkleistung geeignete Messwerte erfasst werden.

Die Wirkleistungs-Werte werden entsprechend ihrer zeitlichen Abfolge in einen Datenpuffer 22 der Einrichtung 14 geschrieben. Der Datenpuffer 22 wird hierbei als Ringspeicher betrieben, d.h. für jeden neu hinzukommenden Wirkleistungs-Wert wird der jeweils älteste im Datenpuffer 22 vorhandene Wirkleistungs-Wert gelöscht. Die Speicherkapazität eines solchen Datenpuffers 22 kann beispielsweise derart beschaffen sein, dass eine Zeitdauer von 40s in dem Datenpuffer abgebildet werden kann. Beispielsweise können Werte der Pendelgröße mit einer Abtastrate von 50 Werten pro Sekunde erfasst und in den Datenpuffer geschrieben werden.

Aus den im Datenpuffer 22 vorhandenen Wirkleistungs-Werten werden mittels einer Recheneinrichtung 23 der Einrichtung 14 Parameter berechnet, die als eine Pendelung in dem Energieversorgungsnetz charakterisierende Kenngrößen verwendet werden können.

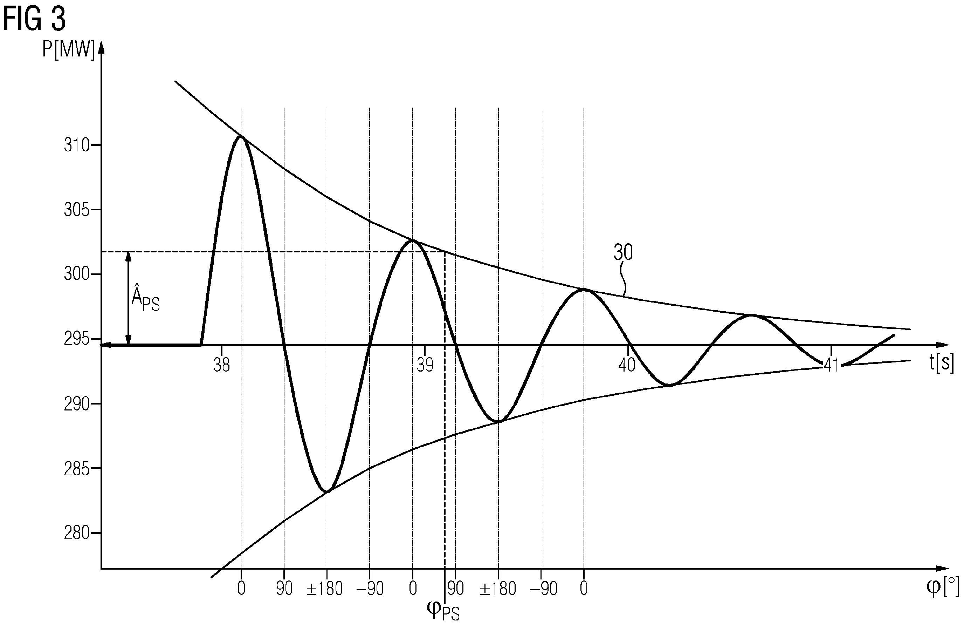

Figur 3 zeigt hierzu beispielhaft den Verlauf von Wirkleistungs-Größen während einer gedämpften Pendelung. Umhüllende Kurven geben hierbei den Verlauf der Amplitude A der Pendelung an, aus der Änderung des Verlaufs lässt sich die Dämpfung der Pendelung bestimmen. Berechnungsmethoden zur Bestimmung der Parameter "Amplitude" und "Dämpfung" sind in der eingangs genannten EP 2774242 B1 bekannt, auf die hiermit explizit referenziert wird.

Die berechneten Parameter können beispielsweise auf der Betriebsstation 17 dem Betriebspersonal einer Netzleitstelle zur Anzeige gebracht werden. Dabei können die Parameter z.B. tabellarisch oder in Form eines Diagramms dargestellt werden. Es ist zudem alternativ oder zusätzlich auch möglich, dass mit der Recheneinrichtung 23 eine Risikoeinstufung einer vorliegenden Pendelung anhand der Parameter vorgenommen wird und das Ergebnis dieser Risikoeinstufung auf der Betriebsstation angezeigt wird. Ein Beispiel zur Bestimmung einer Gefährdungskenngröße ist ebenfalls aus der EP 2774242 B1 bekannt.

Außerdem kann mit der Recheneinrichtung 23 ein Warnsignal erzeugt werden, wenn die Parameter eine besonders gefährliche Pendelung, insbesondere eine schwach gedämpfte oder sogar ansteigende Pendelung anzeigen. Dieses Warnsignal kann ebenfalls auf der Betriebsstation ausgegeben werden, um dem Betriebspersonal die Möglichkeit zur Einleitung geeigneter Gegenmaßnahmen zu geben. Alternativ kann auch vorgesehen sein, dass automatische Gegenmaßnahmen eingeleitet werden. Dies ist schematisch in Figur 2 durch einen mit der Einrichtung über eine Kommunikationsverbindung verbundenen Schalter 24 angedeutet. Automatische Gegenmaßnahmen können im Zu- oder Abschalten bestimmter Netzteile, Lasten oder Erzeuger bestehen. Außerdem können Netzfilter und/oder kapazitive bzw. induktive Elemente eingesetzt werden, um vorliegende Pendelungen zu dämpfen und das Netz zu stabilisieren.

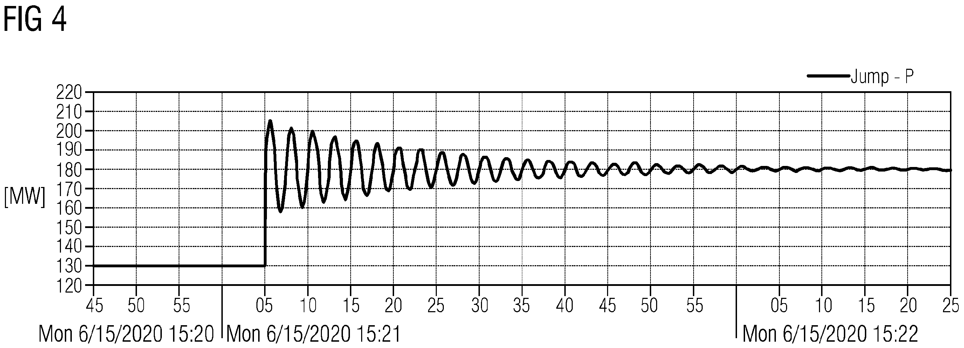

Nachfolgend wird auf die Berechnung der Parameter anhand einer adaptiv angepassten Anzahl von Wirkleistungs-Werten eingegangen. Hierzu zeigt Figur 4 einen beispielhaften Verlauf von Wirkleistungs-Werten während einer Pendelung. Eine solche Pendelung kann beispielsweise aufgrund einer plötzlichen Veränderung im Energieversorgungsnetz, z.B. beim Abschalten einer einzelnen Leitung einer Doppelleitung, entstehen.

Würde man statisch eine konstante Anzahl von Werten zur Berechnung der Parameter heranziehen, beispielsweise, indem man einen Datenpuffer (im Folgenden auch "Puffer" genannt) mit fest vorgegebener Länge mit zeitlich aufeinanderfolgenden Werten der elektrischen Wirkleistung füllt, würden sich zu Beginn einer Pendelung falsche Parameter ergeben. Ist der Puffer vollständig gefüllt, werden die enthaltenen Werte bzw. Daten in den Frequenzbereich transformiert, dort die für eine oder mehrere Pendelungen charakteristischen Frequenzen ermittelt und die zugehörigen Amplituden bestimmt. Wird der Puffer nun mit jedem neuen Wirkleistungs-Wert aktualisiert, kann weitergehend aus der Veränderung der Amplitude die Dämpfung der Pendelung ermittelt werden. Die Parameter "Amplitude" und "Dämpfung" werden somit jeweils aus einer konstanten Anzahl von Wirkleistungs-Werten berechnet. Nachteil dieser Methode ist, dass mit Beginn einer Pendelung zunächst nur ein kleiner Teil des Puffers mit den für die Pendelung charakteristischen Daten gefüllt ist, so dass beispielsweise eine hohe Amplitude der Pendelung zu diesem Zeitpunkt lediglich zu einer kleinen Amplitude im zugehörigen Frequenzspektrum führt.

Bei einer gedämpften Pendelung klingt die tatsächliche Amplitude nach Beginn der Pendelung mit zunehmender Zeit ab; dahingegen steigt die Amplitude im berechneten Frequenzspektrum aufgrund des stetig zunehmenden Anteils der Pendelung im Datenpuffer des Zeitbereichs zunächst weiter an und erreicht bei gedämpfter Pendelung schließlich ein Maximum, wenn der Puffer über seine gesamte Länge erstmalig vollständig mit Daten der Pendelung gefüllt ist. Bei einer ungedämpften Pendelung würde die Amplitude dahingegen weiter ansteigen. Bis zu diesem Zeitpunkt des Maximums ergibt die Auswertung zeitlich aufeinanderfolgender Amplituden im Frequenzspektrum zu gegebener Pendelfrequenz daher als Ergebnis eine ungedämpfte, aufklingende Pendelung, verbunden mit einer möglichen und dann fehlerhaften Alarmierung.

Mit anderen Worten würde bei Verwendung einer konstanten Anzahl von Werten zur Berechnung der Parameter zunächst eine fehlerhafte Berechnung der Parameter erfolgen.

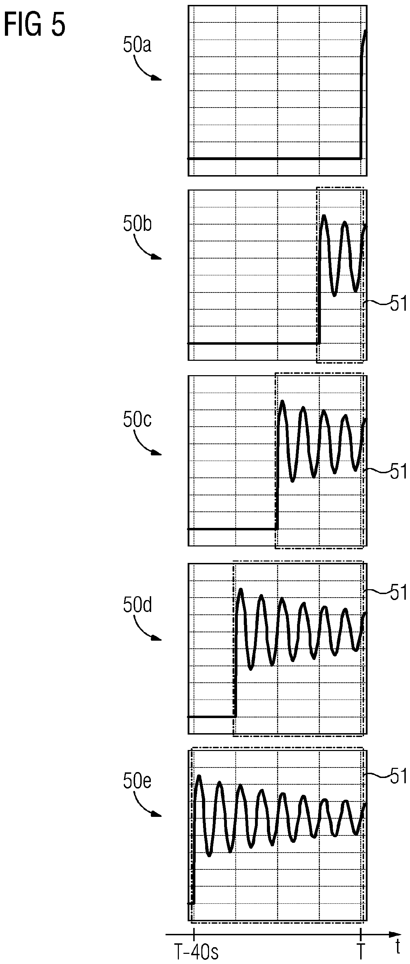

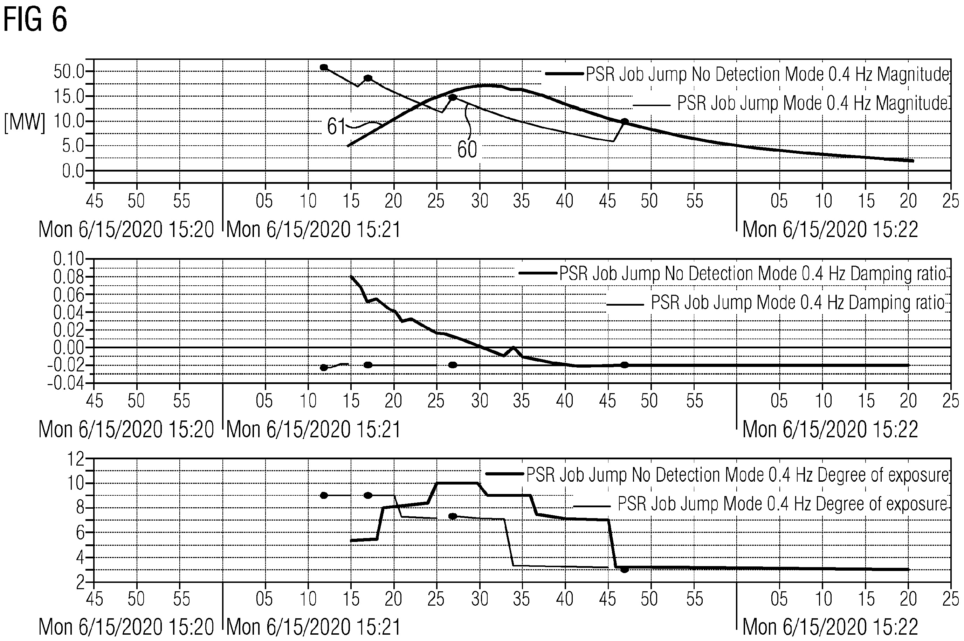

Hierzu soll Figur 5 betrachtet werden. Regelmäßig, z.B. jeweils zur vollen Sekunde, wird der Puffer ausgewertet, dessen einer Rand auf der Echtzeit T liegt und dessen anderer Rand der Echtzeit minus z.B. 40s (T-40s) entspricht. Damit sind nur wenige Sekunden nach Beginn einer Pendelung sowohl ein hoher Anteil vom Signal des Vorzustands als auch der Pendelungsbeginn selbst im Puffer enthalten (vgl. z.B. Diagramm 50a der Figur 5). Der Anteil an Schwingungssignalen wird von Zeitschritt zu Zeitschritt größer (vgl. Diagramme 50b-d), weil der Datenpuffer stetig mit einer größeren Anzahl von Wirkleistungs-Werten während der Pendelung aufgefüllt wird, die ältere - nicht zur Pendelung gehörende - Wirkleistungs-Werte verdrängen. Dies führt rechnerisch zu einer ansteigenden Amplitude (vgl. Kurve 60 in Figur 6), obwohl tatsächlich die Amplitude der Schwingung abnimmt (vgl. Diagramm in Figur 4). Damit wird die Dämpfung der Pendelung zu schlecht und ihr Gefährdungsgrad zu hoch bewertet. Schließlich ist der Datenpuffer vollständig mit Wirkleistungs-Werten, die während der Pendelung aufgenommen worden sind, gefüllt (vgl. Diagramm 50e in Figur 5). Ab diesem Zeitpunkt können korrekte Parameter berechnet werden. Dies führt zu einer Verzögerung von mehreren Sekunden, während der keine oder im schlimmsten Fall sogar schädliche Maßnahmen eingeleitet werden könnten.

Mit dem vorliegend vorgeschlagenen Vorgehen besitzt der Datenpuffer im Zeitbereich nicht wie in der zuvor beschriebenen Lösung eine fest vorgegebene Länge, sondern wird dynamisch an die tatsächliche Länge der Pendelung angepasst. Dies kann entweder durch dynamische Ansteuerung der physikalisch zur Speicherung der Werte zu Verfügung gestellten Speicherzellen oder durch Platzierung eines Datenfensters mit dynamischer Länge erfolgen. Die letztgenannte Alternative ist durch ein entsprechendes Datenfenster 51 mit dynamischer Länge in Figur 5 angedeutet. Man erkennt, dass das zur Auswahl der zur Berechnung der Parameter heranzuziehenden Werte verwendete Datenfenster 51 mit jedem Diagramm 50b-50e eine ansteigende Länge annimmt und sich so der Pendelung anpasst.

Der Beginn des Puffers (linker Rand des Datenfensters 51 in den Diagrammen in Figur 5) ist dabei durch den Zeitpunkt der Erkennung der Pendelung definiert. Die Erkennung selbst kann z.B. durch eine Sprungerkennung, also einen hinreichend großen Anstieg der Wirkleistung innerhalb eines vorgegebenen, kurzen Zeitraums durchgeführt werden.

Die zur Berechnung der Parameter ausgewählten Werte werden nachfolgend in den Frequenzbereich transformiert. Beispielsweise erfolgt die Transformation über eine Fast-FourierTransformation (FFT). Diese erfordert für die Eingangsdaten im Zeitbereich einen Puffer mit einer Länge, die einer Anzahl zeitlich aufeinanderfolgender Werte gemäß einer Zweier-Potenz entspricht. Damit kann es vorteilhaft sein, die Anzahl für die Berechnung der Parameter ausgewählter Werte nicht kontinuierlich anzupassen, sondern stattdessen eine Anpassung in Stufen, bei der FFT bevorzugt in 2er-Potenzen, durchzuführen.

Bei einer solchen gestuften Anpassung wird die nächsthöhere Stufe, z.B. der Sprung von 2³ auf 2⁴, erst dann verwendet, wenn die Anzahl derjenigen Werte, die tatsächlich von der Pendelung beeinflusst sind, mindestens dieser nächsthöheren Stufe (hier 2⁴) entspricht. Entspricht somit nach der Erkennung des Beginns einer Pendelung zu verschiedenen Auswertezeitpunkten die Anzahl der Werte im Zeitbereich noch nicht der nächst größeren Stufe (z.B. 2⁴), werden nur die der aktuellen Stufe (z.B. 2³) entsprechenden jüngsten Werte der weiteren Auswertung unterworfen. Erst wenn die Anzahl der Werte im Zeitbereich die nächst größere Stufe (z.B. 2⁴) erreicht hat, werden diese in ihrer Gesamtheit der weiteren Auswertung zugeführt. Figur 6 zeigt mit Kurve 61 ein Ergebnis einer solchermaßen gestuft durchgeführten Berechnung des Parameters "Amplitude". Der beschriebene Vorgang wird so lange fortgesetzt, bis eine zuvor festgelegte Obergrenze für die Anzahl der auszuwertenden Daten im Zeitbereich erreicht worden ist. Diese sollte mindestens so gewählt werden, dass einerseits die Pendelung mit der höchsten zu ermittelnden Pendelfrequenz mit hinreichender Genauigkeit ausgewertet werden kann. Andererseits sollten zeitlich länger zurückliegende Datenbereiche einen möglichst geringen Einfluss auf die aktuellen Ergebnisse haben, was durch eine entsprechend kurze Puffer-Länge erreicht werden kann. Durch die letztgenannte Anforderung wird vermieden, dass z.B. bei einer tatsächlich schnell abklingenden Pendelung deren Amplitude aufgrund des vergleichsweise hohen realen Anfangswertes für die nachfolgenden Zeitpunkte in den Ergebnissen der Auswertung tendenziell zu hoch angezeigt wird.

Weiterhin können die aus den Werten der Pendelgröße bestehenden Daten vor ihrer Übergabe an die FFT mit einer geeigneten Fensterfunktion gefaltet werden, damit die Daten im Zeitbereich durch eine Wiederholung des Musters periodisch fortgesetzt werden könnten, um durch Sprungstellen an den Rändern verursachte Artefakte in dem durch Anwendung der FFT auf die Daten im Zeitbereich erhaltenen Frequenzspektrum zu vermeiden. Die zeitliche Länge einer solchen Fensterfunktion wird hierzu dynamisch an die Länge des Zeitbereichs der auszuwertenden Daten angepasst. Als Fensterfunktion kann z.B. ein Hanning-Fenster Verwendung finden.

Unter Annahme einer Gauß-Verteilung der Amplituden im nach der FFT ersichtlichen Frequenzspektrum um die Pendelfrequenz herum wird vorgeschlagen, den Logarithmus der Amplitudenverteilung als Funktion der Frequenz zu bilden und nachfolgend den genauen Wert der Pendelfrequenz durch einen quadratischen Fit zu ermitteln. Da hierzu mindestens drei Werte im Frequenzspektrum verfügbar sein müssen, wird als kleinste Anzahl der verfügbaren Daten im Zeitbereich ein Wert von 8 (2³) vorgeschlagen.

Bei Erreichen der nächst höheren Stufe für die Anzahl der Wirkleistungs-Werte im Zeitbereich zeigt der Verlauf der so ermittelten Pendelamplitude in der Regel einen Sprung (vgl. Kurve 61 in Figur 6). Bei einer abklingenden Pendelung erfolgt hierbei infolge der vergleichsweise größeren Amplituden der nun berücksichtigten, länger zurückliegenden Werte tendenziell ein Sprung nach oben, bei einer aufklingenden Pendelung infolge der nun beitragenden kleineren Amplitudenwerte ein solcher nach unten. Zur Kenntnismachung der Ursache wird vorgeschlagen, die Amplitudenwerte für diesen Zeitpunkt entsprechend zu kennzeichnen.

Um verlässliche Daten zu erhalten, wird weiterhin vorgeschlagen, nur solche Daten zu verwerten, die eine minimale Dauer der zugehörigen Pendelung umfassen. Hierzu wird nach Erkennung eines für eine Pendelung charakteristischen Peaks im Frequenzspektrum der zugehörige Frequenzwert, z.B. durch Bestimmung des Maximums des Peaks, bestimmt und daraus die zugehörige, in den Eingangsdaten der FFT enthaltene Anzahl von Pendelungs-Perioden. Ist diese kleiner als die vorgegebene minimale Anzahl von Perioden der Pendelung, z.B. zwei, erfolgt für diesen Zeitpunkt keine weitere Auswertung des Peaks für diese Frequenz ("2-Perioden-Kriterium").

Für die Ermittlung des Dämpfungsverhältnisses wird im einfachsten Fall die Differenz zweier aufeinander folgender Amplitudenwerte betrachtet. Für eine tatsächlich abklingende Pendelung würde zum Zeitpunkt des Erreichens der nächst höheren Stufe aufgrund der vorhergehenden Betrachtung in der Auswertung ein Anstieg der Amplitude und damit fälschlicherweise ein eine aufklingende Pendelung charakterisierender Wert der Dämpfung resultieren. Zusammen mit einer hinreichend hohen Pendelamplitude würde weitergehend ein hoher Wert eines Risikopotenzials für diese Pendelung resultieren. Zur Vermeidung dieses Effektes und damit einhergehend einer möglichen Alarmierung wird vorgeschlagen, zu einem Zeitpunkt, bei dem auf die nächste Stufe umgeschaltet wird, die Ermittlung des Dämpfungsverhältnisses zu unterdrücken oder alternativ den Wert einer so ermittelten Dämpfung als ungültig zu kennzeichnen.

Für die Detektion von Pendelungen wird also zusammengefasst eine in dem beschriebenen Ausführungsbeispiel eine Fast Fourier Transformation (FFT) der Eingangssignale (z.B. Wirkleistungs-Werte) vom Zeitbereich in den Frequenzbereich ausgeführt. Zur besseren Detektion werden Puffer bzw. Datenfenster mit unterschiedlichen Längen verwendet, um ein Optimum zwischen frühzeitiger Detektion und Genauigkeit der charakteristischen Größen zu erreichen. Wenn die absolute Differenz zweier aufeinander folgender Wirkleistungs-Werte größer als ein vorgegebener Grenzwert ist, wird ein Sprung erkannt und damit der Rand des Auswertebereichs auf den Zeitpunkt des Sprungs gesetzt, so dass ausschließlich der Zeitbereich der Pendelung im Puffer ausgewertet wird.

Für die Auswertung des Puffers durch die FFT muss die Anzahl der Samples auf einen Wert 2^{N} mit N = {3, 4, 5, ...} verkürzt werden. Dazu wird gegebenenfalls der linke Rand des Auswertebereichs weiter nach rechts verschoben (2^{N}-Kriterium). Durch das Versetzen des linken Rands des Auswertepuffers kann der verbleibende Puffer so klein sein, dass eine Auswertung im aktuellen Zeitschritt nicht ohne hinreichende Genauigkeit möglich ist. Die Ergebnisse einer FFT werden dann nicht weiterverwendet. In darauffolgenden Zeitschritten wird gegebenenfalls der Auswertebereich des Puffers wieder vergrößert, sobald die Anzahl der Samples seit der sprungförmigen Änderung größer ist als 2^{(N+1)}. Dadurch wird die Genauigkeit der Ergebnisse verbessert. Dies erfolgt, bis die maximale Puffergröße (und damit die maximale Genauigkeit) erreicht ist.

Bei einer abklingenden Pendelung führt eine Vergrößerung des Auswertebereichs des Puffers zum Ansteigen der Amplitude von einem Zeitschritt zum nächsten (Kurve 61 in Figur 6), da im Auswertebereich im Gegensatz zum vorhergehenden Zeitschritt nun wieder mehr Daten des Anfangszeitbereichs der Pendelung liegen. Da dies aber durch den Algorithmus bestimmt ist, wird das Ergebnis der Amplitude für den Zeitpunkt der Auswertebereichsvergrößerung mit der Qualitätsinformation "nicht verlässlich" gekennzeichnet. Eine Bewertung der Pendelung hinsichtlich Dämpfung und Gefährdungsgrad unterbleibt, Alarme oder Ereignisse werden nicht ausgegeben.

Zur Veranschaulichung der beschriebenen Vorgehensweise gibt Tabelle 1 die dynamische Puffergröße für ein Feldgerät, z.B. eine PMU, mit 50 Messwerten pro Sekunde während der Auswertung der den Figuren 4 und 6 zugrunde liegenden Pendelung wieder. Die Spalte "Samples von PMU" gibt die Anzahl der Samples mit Daten der Pendelung wieder, die Spalte "Samples nach FFT" die Anzahl von Samples, die zur Auswertung durch die FFT übergeben werden. Die Periodendauer beträgt 2,5 s.

| **Zeitpunkt** | **Samples von PMU** | **Samples nach FFT** | **Pufferlänge [s]** | **Kommentar** |
|---|---|---|---|---|
| 15:21:05 | 0 | 0 | 0 | Eintritt des Ereignisses |
| 15:21:06 | 50 | 32 | 0,64 | kein Ereignis gemäß 2-Perioden-Kriterium |
| 15:21:07 | 100 | 64 | 1,28 | |
| 15:21:08 | 150 | 128 | 2,56 | |
| 15:21:09 | 200 | 128 | 2,56 | |
| 15:21:10 | 250 | 128 | 2,56 | |
| 15:21:11 | 300 | 256 | 5,12 | |
| 15:21:12 | 350 | 256 | 5,12 | Amplitude kann berechnet werden, aber nicht Dämpfungsverhältnis und Kritikalität. Deswegen wird nur die Amplitude ausgegeben. |
| 15:21:16 | 550 | 512 | 10,24 | Verlängerung des Puffers, somit anteilig mehr Schwingungsdaten mit hoher Amplitude, deshalb Amplitude ansteigend und als nicht verlässlich gekennzeichnet. Bewertung von Dämpfung und damit Gefährdungsgrad ausgesetzt. |
| 15:21:26 | 1050 | 1024 | 20,48 | Verlängerung des Puffers, siehe auch 15:21:16 |
| 15:21:46 | 2048 | 2048 | 40, 96 | Verlängerung des Puffers, siehe auch 15:21:16, maximale Puffergröße erreicht |
| 15:22:21 | 2048 | 2048 | 40, 96 | Amplitude fällt unter die Detektionsschwelle, keine Ausgabe von Ergebnissen, Schwingungskreis beendet |

Figur 6 zeigt den Vergleich der Auswerteergebnisse für die Parameter "Amplitude", "Dämpfung" und den daraus abgeleiteten Gefährdungsgrad basierend auf der in Figur 4 gezeigten Pendelung bei einer Pendelfrequenz von 0,4Hz. Dabei werden immer die Ergebnisse mit und ohne dynamische Anpassung der Anzahl der zur Berechnung der Parameter ausgewählten Wirkleistungs-Werte nebeneinander dargestellt. Es ist erkennbar, dass ab einer Zeit von t=15:21:46 die Ergebnisse für beide Varianten aufgrund derselben verwendeten Anzahl gleich sind und demzufolge nur die Kurven für die Variante ohne Sprungerkennung sichtbar sind.

Mit der oben beschriebenen Vorgehensweise kann eine frühzeitige Information über das Vorliegen und die Art einer elektrischen Pendelung im elektrischen Energieversorgungsnetz erreicht werden. Dieses wird erreicht durch eine dynamische Anpassung der zur Auswertung verwendeten Werte an die Menge der zur Verfügung stehenden, während der Pendelung bestimmten Messdaten. Damit verbunden kann eine vergleichsweise genaue Ermittlung von Parametern zur Beschreibung der Pendelung bereits zu einem frühen Zeitpunkt erfolgen, für den erst geringe Datenmengen vorliegen. Dies ist insbesondere dann von Interesse, wenn auf Grundlage der Ergebnisse manuelle oder automatische Schaltmaßnahmen im Netz geplant sind.

Zusammengefasst hat das beschriebene Verfahren damit unter anderem die folgenden Vorteile:
- eine Pendelung wird früher erkannt;
- die Amplitude einer Pendelung wird auch zu Beginn der Pendelung korrekt berechnet;
- damit ist die Dämpfung ebenfalls von Beginn der Pendelung an korrekt (negativ anstatt positiv bei gedämpfter Pendelung) ;
- ein Gefährdungsgrad der Pendelung kann frühzeitig korrekt ermittelt werden.

Obwohl die Erfindung vorstehend im Detail durch bevorzugte Ausführungsbeispiele näher illustriert und beschrieben worden ist, ist die Erfindung nicht durch die offenbarten Beispiele eingeschränkt und andere Variationen können vom Fachmann hieraus abgeleitet werden, ohne den Schutzumfang der nachfolgenden Patentansprüche zu verlassen.

## Patentansprüche

1. Verfahren zum Erkennen einer elektrischen Pendelung in einem elektrischen Energieversorgungsnetz, bei dem
- für zumindest eine Messstelle (21) in dem Energieversorgungsnetz eine elektrische Pendelgröße bestimmt wird;
- auf Basis eines zeitlichen Verlaufs der Pendelgröße für die zumindest eine Messstelle (21) Parameter einer Pendelung berechnet werden; und
- unter Verwendung der Parameter auf das Vorliegen und die Art einer elektrischen Pendelung geschlossen wird;
**dadurch gekennzeichnet, dass**
- die Anzahl derjenigen aufeinanderfolgenden Werte der Pendelgröße, aus denen die Parameter der elektrischen Pendelung berechnet werden, dynamisch an den Verlauf der Werte der Pendelgröße angepasst wird.

2. Verfahren nach Anspruch 1,
- die Pendelgröße eine elektrische Wirkleistung oder eine der Wirkleistung proportionale Größe ist.

3. Verfahren nach Anspruch 1 oder 2,
**dadurch gekennzeichnet, dass**
- die Werte der Pendelgröße in einen Datenpuffer (22) geschrieben werden, der als Ringspeicher betrieben wird.

4. Verfahren nach Anspruch 3,
**dadurch gekennzeichnet, dass**
- die Länge eines Datenfensters (51), das festlegt, welche in dem Datenpuffer (22) enthaltenen Werte der Pendelgröße zur Berechnung der Parameter verwendet werden, dynamisch an den Verlauf der Werte der Pendelgröße angepasst wird.

5. Verfahren nach Anspruch 3,
**dadurchg ekennzeichnet**, dass
- die Größe des Datenpuffers (22) dynamisch an den Verlauf der Werte der Pendelgröße angepasst wird.

6. Verfahren nach einem der vorangehenden Ansprüche,
**dadurch gekennzeichnet, dass**
- der Beginn einer elektrischen Pendelung erkannt wird; und
- für die Berechnung der Parameter der elektrischen Pendelung diejenigen Werte der Pendelgröße herangezogen werden, die nach dem Beginn der elektrischen Pendelung bestimmt worden sind.

7. Verfahren nach einem der vorangehenden Ansprüche,
**daurch gekennzeichnet,** dass
- zur Berechnung der Parameter eine Transformation der Werte der Pendelgröße in den Frequenzbereich durchgeführt wird.

8. Verfahren nach einem der vorangehenden Ansprüche,
**dadurch gekennzeichnet, dass**
- die Anzahl der zur Berechnung der Parameter verwendeten Werte der Pendelgröße einem Wert einer Zweierpotenz 2^{N} entspricht.

9. Verfahren nach einem der vorangehenden Ansprüche,
**dadurch gekennzeichnet, dass**
- als Parameter der elektrischen Pendelung eine Amplitude und eine Dämpfung der elektrischen Pendelung berechnet werden.

10. Verfahren nach einem der vorangehenden Ansprüche,
**dadurch gekennzeichnet, dass**
- die berechneten Parameter auf einer Anzeigevorrichtung einer das Energieversorgungsnetz überwachenden Datenverarbeitungseinrichtung angezeigt werden.

11. Verfahren nach einem der vorangehenden Ansprüche,
**dadurch gekennzeichnet, dass**
- für den Fall, dass die berechneten Parameter eine ungedämpfte elektrische Pendelung angeben, ein Warnsignal erzeugt wird.

12. Verfahren nach Anspruch 11,
**dadurch gekennzeichnet, dass**
- bei vorliegendem Warnsignal eine zur Dämpfung einer elektrischen Pendelung geeignete Gegenmaßnahme ausgelöst wird.

13. Einrichtung (14) zum Erkennen einer elektrischen Pendelung in einem elektrischen Energieversorgungsnetz, mit einer Recheneinrichtung (23), die dazu eingerichtet ist,
- für zumindest eine Messstelle (21) in dem Energieversorgungsnetz eine elektrische Pendelgröße zu bestimmen;
- auf Basis eines zeitlichen Verlaufs der Pendelgröße für die zumindest eine Messstelle (21) Parameter einer elektrischen Pendelung zu berechnen; und
- unter Verwendung der Parameter auf das Vorliegen und die Art einer elektrischen Pendelung zu schließen;
**dadurch gekennzeichnet, dass**
- die Recheneinrichtung (23) dazu eingerichtet ist, die Anzahl derjenigen aufeinanderfolgenden Werte der Pendelgröße, aus denen die Parameter der elektrischen Pendelung berechnet werden, dynamisch an den Verlauf der Werte der Pendelgröße anzupassen.

14. System zum Erkennen einer elektrischen Pendelung in einem elektrischen Energieversorgungsnetz, mit mindestens einer Einrichtung (14) nach Anspruch 13, wobei die mindestens einer Einrichtung (14) dazu ausgebildet ist, nach einem Verfahren gemäß einem der Ansprüche 1 bis 12 für mindestens zwei Messstellen (21) in dem elektrischen Energieversorgungsnetz Parameter der elektrischen Pendelung zu bestimmen.
